# EUROPEAN PATENT SPECIFICATION

(11) **EP 1 425 896 B1**
(45) Date of publication and mention of the grant of the patent: **30.08.2006**
(21) Application number: 02745352.1
(22) Date of filing: 03.06.2002
(51) Int. Cl.: H04M 1/02, H05K 5/00

(54) **ELECTRONIC DEVICES AND CASING CONSTRUCTIONS FOR SUCH DEVICES**
ELEKTRONISCHE GERÄTE UND GEHÄUSEKONSTRUKTION FÜR SOLCHE GERÄTE
DISPOSITIFS ELECTRONIQUES ET CONSTRUCTIONS DE BOITIERS POUR CES DISPOSITIFS

(30) Priority: 01.09.2001 GB 0121242
(43) Date of publication of application: 09.06.2004
(73) Proprietor: MOTOROLA, INC., Schaumburg, IL 60196 (US); Rotman, Ariel, 52960 Ramat-Efal (IL); Mosseri, Yakov, 76250 Shoam (IL); Motorola Limited, Basingstoke, Hampshire RG22 4PD (GB)
(72) Inventor: MARGALIT, Eli, 43401 Raanana (IL)
(74) Representative: McCormack, Derek James
(86) International application number: PCT/EP2002/006072
(87) International publication number: WO 2003/021921

(56) References cited:
- US-A- 4 090 632
- US-A- 4 711 361
- US-A- 5 107 404
- US-A- 5 394 306

## Description

### Field of the Invention

This invention relates to electronic devices and casing constructions for such devices.

### Background of the Invention

In the electronics industry, especially in the audio - video - computer - communications (AVCC) sector, there is a constant drive to reduce the size and weight of products and to make them more easily portable. One of the ways in which this is achieved is to use suitably lightweight and strong materials as constructional materials.

Plastics materials with and without reinforcement have for many years been widely used as constructional materials for electronic devices. However, metallic materials, especially magnesium based materials, have started to find uses for this application. Magnesium has a density which is roughly two thirds that of aluminium and is only slightly higher than that of fibre reinforced plastics yet has excellent mechanical and physical properties as well as good processibility and recyclability. Magnesium based materials potentially offer other benefits in the electronics industry, such as good shielding from electromagnetic interference (EMI) and good thermal conductivity which facilitates heat dissipation from components, e.g. when contained in a case made of the material. Thus, magnesium based materials are seen as attractive alternatives to plastics materials for use as constuctional materials in the electronics industry, especially the AVCC sector.

However, magnesium is a very malleable material and casing structures made from magnesium based materials may be easily deformed especially when a device which is encased by the material is dropped or otherwise mishandled and therefore subjected to external mechanical shock. This may easily lead to damage of components of an electronic device encased within a magnesium alloy casing.

Conventional casing structures for an electronic device are disclosed in US-A-5 107 404 and US-A-4 711 361.

The present invention seeks to provide a novel improved casing structure for an electronic device.

### Summary of the invention

According to the present invention in a first aspect there is provided a casing structure for an electronic device comprising a carrier against which one or more of the device components may be fitted, the carrier having a first carrier face and a second carrier face, a first cover adapted to attach to the carrier to form a first enclosure over at least part of the first carrier face and a second cover adapted to attach to the carrier to form a second enclosure over at least part of the second carrier face, wherein the carrier has a receptacle for receiving the first and second covers, the receptacle having a first recess for receiving a rim of the first cover and a second recess for receiving a rim of the second cover, the receptacle having in at least one of the first and second recesses a cushioning layer for cushioning the cover received in the recess, wherein the first and second recesses of the receptacle provide push fits for the rims of the first and second covers respectively.

The first and second faces of the carrier may conveniently be on opposite sides of the carrier and may point in mutually opposite directions.

The said receptacle may be formed separately from the carrier and attached thereto but preferably the receptacle is formed integrally with the carrier. For example, the carrier including the receptacle preferably comprises a substantially rigid part made of moulded plastics material.

The receptacle desirably extends around the carrier at an edge or periphery thereof. The receptacle may form a closed loop around the edge or edges of the carrier.

The first recess and the second recess are conveniently on mutually opposite sides of the receptacle. For example, the first recess may be provided in the receptacle on the same side of the carrier as a front face of the carrier and the second recess may be provided in the receptacle on a rear face of the carrier.

The receptacle may conveniently have, at least in the parts thereof which are adjacent to the recesses, a cross-sectional shape which approximates to a letter H.

In the casing according to the invention the cushioning layer may comprise a strip of elastomeric material. The kind of material used as the elastomeric material is not critical, but the material selected should give good cushioning and resilience. For example, the material may be a silicone rubber.

Preferably, a cushioning layer is provided in both of the first and second recesses. Such layers may comprise two cushioning rings manufactured separately and fitted into the recesses during assembly of the device.

In the casing construction according to the first aspect of the invention the first and second covers may usefully comprise metallic material. The metallic material may be a magnesium based material, e.g. a material such as an alloy containing at least 80%, in many cases at least 95%, by weight magnesium.

In the casing according to the first aspect of the invention, the first and second covers may also have attachments to the carrier additional to that provided by the receptacle. For example, the first cover and the carrier on its first face may have complementary formations which facilitate attachment of the first cover to the carrier and the second cover and the carrier on its second face may have complemetary formations which facilitate attachment of the second cover to the carrier. The respective complementary formations may conveniently provide push fits, especially tight fits, of the first and second covers to the carrier, the first and second covers when attached to the carrier thereby being clamped thereto. The complementary formations may for example be cylindrical holes and plugs which fit therein. For example, such holes may be provided in the carrier in corner regions thereof and complementary plugs may be provided on the inner faces of the covers.

The casing construction according to the invention may be such that at least one of the faces of the carrier has a wall providing an internal protection zone to one or more sensitive components of the electronic device. The wall may form in shape a closed loop figure. A layer of cushioning material may be provided on the inside of the wall. The layer may comprise a rubber ring.

According to the present invention in a second aspect there is provided an electronic device having a casing structure according to the first aspect. The device may for example be a hand held portable device. The device may for example comprise a radio communications unit, such as a terminal for the transmission and receipt of data and/or speech signals and/or video or other picture signals.

The device may incorporate standard components to provide these operations. For example, the device may include as components fitted against the carrier one or more printed circuit boards carrying keyboard, processor and radio circuit components, an electro-optical display such as a liquid crystal display and optionally an electro-optical scanner, an antenna and optionally a microphone and a speaker. One or more of these components such as the electro-optical display which is regarded as particularly sensitive to mechanical shock may be enclosed within an internally cushioned region as well as protected externally by the casing structure according to the first aspect or the invention. The carrier may have formations such as clips on its faces which allow the device components to be fitted thereto in a known manner. The antenna where included may conveniently be housed in an antenna housing fitted to the carrier at an edge region of the carrier. The antenna may extend from the housing inside an enclosed region between the carrier and one of the covers.

The present invention provides a more rugged electronic device construction using suitable lightweight materials than is available in the prior art, especially for relatively complex hand held portable devices such as radio communications terminals which may optionally incorporate computing units. In particular, the invention allows use of magnesium based material to be used in the construction thereby taking advantage of the benefits provided by magnesium, without the problems caused by easy deformity. In particular, the invention is effective in protecting a device having outer covers made of magnesium based material from external shock such as caused by dropping. In one embodiment the invention can provide two levels of shock resistance to the most sensitive components of the device by providing both internal and external cushioning layers.

We have found in practical tests using the invention that devices made with magnesium based outer covers can be dropped and can withstand shocks caused thereby equivalent to 7000g and that such devices are highly attractive to users.

Other advantages of the invention are that it allows easy, rapid and inexpensive assembly of the device from its components and easy access to the components during use.

Embodiments of the present invention will now be described by way of example with reference to the accompanying drawings, in which:

### Brief description of the accompanying drawings

Fig 1 is a perspective front view of a carrier for use in the construction of an electronic device.
Fig 2 is a cross sectional view (in the plane indicated by the lines II - II viewed in the direction X) of part of the rim structure of the carrier shown in Fig 1.
Fig 3 shows the rim structure of Fig 2 with parts of the rims of covers shown fitted thereon.
Fig 4 is a perspective view of a construction comprising the carrier of Fig 1 with covers fitted thereon.
Fig 5 is a partly cut away perspective view of the construction of Fig 4 with some of the internal components of the device when partly assembled shown fitted against the front face of the carrier of the construction.
Fig 6 shows the construction of Fig 5 with a keybooard receptacle component also fitted.
Fig 7 is a partly cut away perspective view of the construction of Fig 4 with components of the device shown fitted against the rear face of the carrier of the construction.

### Description of illustrative embodiments of the invention

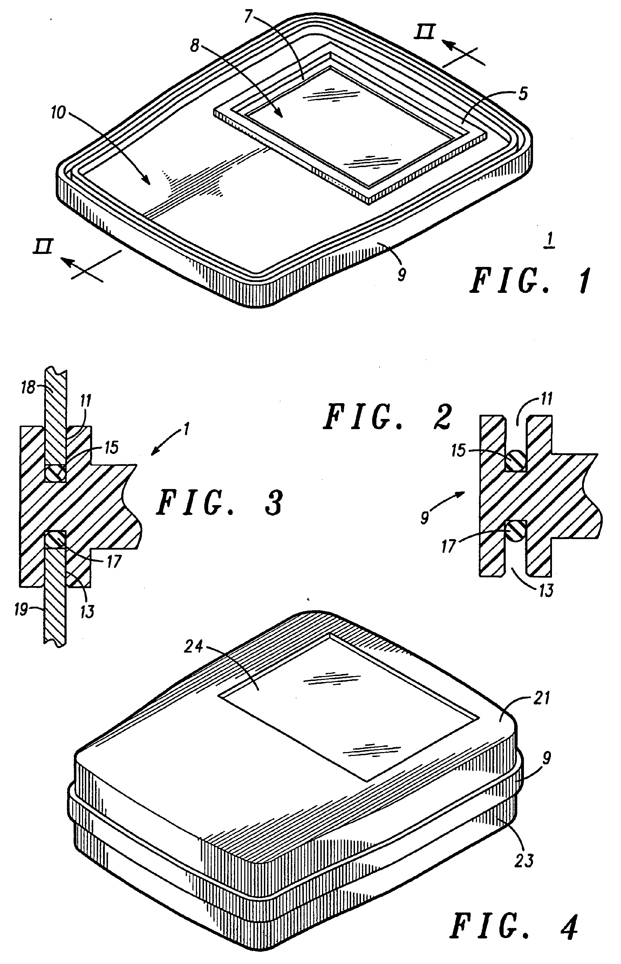

As shown in Fig 1, a carrier 1 moulded from rigid and strong plastics material is provided. The carrier 1 forms the basic body structure of a portable hand held electronic device, namely a radio communications terminal for transmitting data to and from a remote control centre (not shown) and for displaying data such as that sent and received, all in a manner known in the art. The carrier 1 is generally in the form of a flat plate having front and rear faces pointing in opposite directions with projections formed on the faces to provide certain component retaining functions. A front face only is shown in Fig 1. As seen in Fig 1, the shape of the plate forming the carrier 1 is generally rhomboidal with rounded edges and corners. The front face of the carrier 1 has a rectangular wall 5 protruding therefrom and formed integrally therewith in the moulding and a rectangular shaped cushioning strip 7 of soft rubber material is provided inside the wall 5 and lies along the inner edges of the wall 5. The wall 5 and strip 7 provide an internal shock protective barrier for delicate components to be fitted in a region 8 inside the wall as described later. A further region 10 for reception of less delicate components of the device is provided on the front face beneath the region 8. The carrier 1 has an integrally moulded rim structure 9 which runs around the entire periphery of the carrier 1.

As shown in more detail in Fig 2, the rim structure 9 is formed at the periphery of the carrier 1. The rim structure 9 has a shape which approximates to the shape of a letter H in cross section. The rim structure 9 provides a portion of enlarged thickness on the carrier 1 in which is formed a first recess 11 in a front facing part of the rim structure 9 and a second recess 13 in a rear facing part of the rim structure 9. The recesses 11 and 13 run around the entire periphery of the carrier 1 in the rim portion 9. A silicone rubber cushioning ring 15 fits inside the recess 11 and a silicone rubber cushioning ring 17 fits inside the recess 13.

In use, magnesium alloy outer covers are fitted on the carrier 1 when all of the internal device components have been fitted thereon as illustrated later. Rims of the covers are engaged in the receptacle provided by the rim structure 9 of the carrier 1 and the recesses 11 and 13 therein. Figure 3 shows the peripheral part of the carrier 1 with a rim 18 of an upper magnesium alloy cover fitted inside the recess 11 and cushioned by the ring 15 and a rim 19 of a lower magnesium alloy cover fitted inside the recess 13.

Fig 4 shows the completed outer structure of the device with a front magnesium alloy cover 21 fitted over the front face of the carrier 1 and a rear magnesium alloy cover 23 fitted over the rear face of the carrier 1, the covers 21 and 23 having the rims 18 and 19 (Figure 3) which respectively fit into the recesses 11 and 13 of the rim portion 9 of the carrier 1. The cover 21 has a window portion 24 through which a display can be viewed. The display is one of the components fitted inside the device against the carrier 1 as described later.

The rim portion 9 of the carrier 1 and the magnesium alloy covers 21 and 23 fitted thereon provide an excellent protective shield for internal components of the electronic device if the device is accidently dropped or otherwise subjected to a mechanical shock during use. Deformation of the magnesium alloy covers 21 and 23 is prevented or resisted by the cushioning effect of the rings 15 and 17 in the recesses 11 and 13 on the rims 17 and 19 respectively.

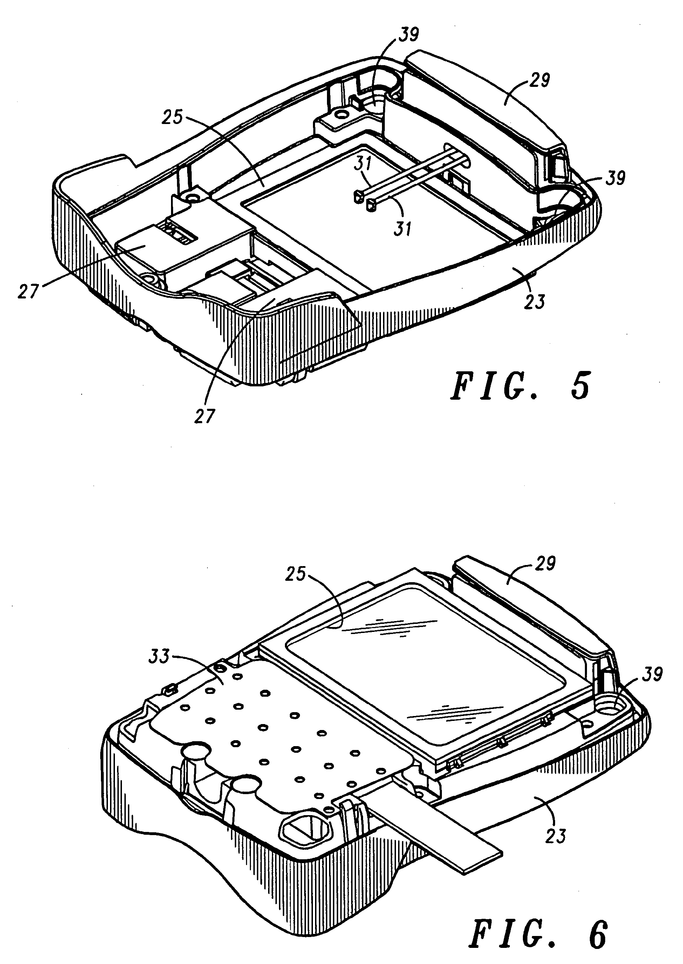

Figs 5,6 and 7 illustrate components which may be present in the device when the covers 21 and 23 are fitted on the carrier 1. Fig 5 shows a partially completed assembly of components on the the carrier 1 on the front face thereof. A window 25 is fitted in the region 8 provided by the wall 5 and strip 7 shown in Figure 1. Circuit components 27 are fitted in the region 10 of the front face beneath the window 25. An antenna housing 29 is fitted on the carrier 1 in a peripheral region above the window 25. An antenna is fitted inside the antenna housing 29 and has pins 31 extending from the antenna housing 29 generally in a plane parallel to the front face of the carrier 1. The pins 31 are attached to an antenna portion (not shown) inside the antenna housing 29 which comprises a conducting plate perpendicular to the plane of the pins 31.

As seen in Fig 6, a circuit board 33 comprising a keyboard receptacle is fitted over the circuit components 27. For simplicity, the antenna housing 29 but not the antenna is shown in Figure 6.

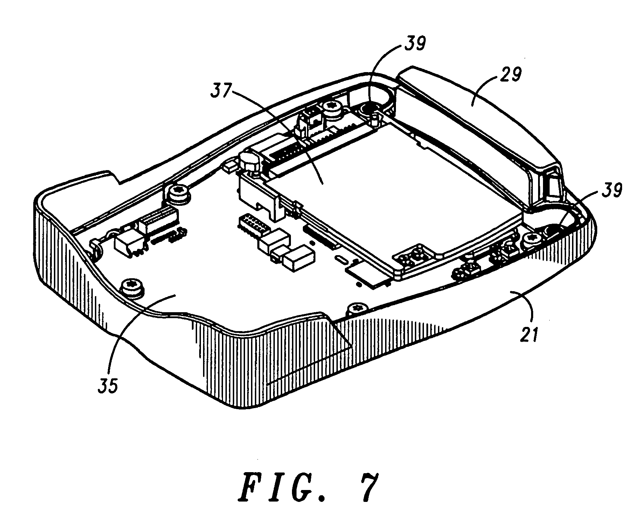

As shown in Fig 7, the rear face of the carrier 1 has fitted thereon a printed circuit board 35 on which various electronic processors and circuit components are carried. These components provide the electronic memory, computing and control functions and radio transmitter and receiver parts of the electronic device. A liquid cystal display 37 is fitted against the rear face of the carrier 1. The rear face only of the display 37 is seen in Fig 7. The front of the liquid crystal display 37 is covered by the window 25 shown in Figs 5 and 6.

Figs 5, 6 and 7 also show cylindrical recesses 39 formed in the carrier 1 in corner regions thereof on the upper and lower faces of the carrier 1. These recesses 39 engage complementary studs (not shown) on the inner faces of the covers thereby providing attachment of the covers to the carrier 1 in addition to the attachment provided by the recesses 11 and 13.

## Claims

1. A casing structure for an electronic device comprising a carrier (1) against which one or more of the device components may be fitted, the carrier having a first carrier face and a second carrier face, a first cover (21) adapted to attach to the carrier to form a first enclosure over at least part of the first carrier face and a second cover (23) adapted to attach to the carrier to form a second enclosure over at least part of the second carrier face, wherein the carrier has a receptacle (9) for receiving the first and second covers, the receptacle having a first recess (11) for receiving a rim (18) of the first cover and a second recess (13) for receiving a rim (19) of the second cover, the receptacle having in at least one of the first and second recesses a cushioning layer (15) for cushioning the cover received in the recess, **characterised in that** the first and second recesses of the receptacle provide push fits for the rims of the first and second covers respectively.

2. A casing structure according to claim 1 and wherein the first and second faces of the carrier point in mutually opposite directions.

3. A casing according to claim 1 or claim 2 and wherein the receptacle is formed integrally with the carrier.

4. A casing according to claim 3 and wherein the carrier including the receptacle comprises a substantially rigid part made of moulded plastics material.

5. A casing according to any one of claims 2 to 4 and wherein the receptacle extends around the carrier at an edge thereof.

6. A casing according to claim 5 and wherein the receptacle forms a closed loop around the edge or edges of the carrier.

7. A casing according to claim 5 or claim 6 and wherein the first recess and the second recess are on mutually opposite sides of the receptacle.

8. A casing according to claim 7 and wherein the receptacle has, at least in the parts thereof which are adjacent to the recesses, a cross-sectional shape which approximates to a letter H.

9. A casing according to any one of the preceding claims and wherein the cushioning layer comprises a strip of elastomeric material.

10. A casing according to any one of the preceding claims and wherein cushioning layers are provided in both of the first and second recesses.

11. A casing according to claim 10 and wherein the cushioning layers in the first and second recesses comprise two cushioning rings.

12. A casing according to any one of the preceding clims and wherein the first and second covers comprise metallic material.

13. A casing according to claim 12 and wherein the first and second covers are made of a magnesium material.

14. A casing according to any one of the preceding claims and wherein the first and second covers have attachments to the carrier additional to the receptacle.

15. A casing according to claim 14 and wherein the first cover and the carrier on the first face thereof have complementary formations which facilitate attachment of the first cover to the carrier and the second cover and the carrier on the second face thereof have complemetary formations which facilitate attachement of the second cover to the carrier.

16. A casing according to claim 15 and wherein the respective complementary formations provide push fits of the first and second covers to the carrier, the first and second covers when attached to the carrier being clamped thereto.

17. A casing according to any one of the preceding claims and wherein at least one of the faces of the carrier has a wall providing an internal protection zone to one or more components of the electronic device.

18. A casing according to claim 17 and wherein the wall forms in shape a closed loop figure and a layer of cushioning material is provided on the inside of the wall.

19. An electronic device having a casing according to any one of the preceding claims.

20. An electronic device according to claim 19 and wherein the device is a hand held portable device and the casing protects against accidental damage to the device by dropping or mishandling by a user.

21. An electronic device according to claim 19 or claim 20 and wherein the device comprises a radio communications unit.

## Patentansprüche

1. Gehäusestruktur für ein elektronisches Gerät, die einen Träger (1) umfasst, an dem ein oder mehrere der Gerätekomponenten montiert sein können, wobei der Träger eine erste Trägerfläche und eine zweite Trägerfläche aufweist, wobei eine erste Abdeckung (21) zum Befestigen an dem Träger angepasst ist, um eine erste Verkleidung über zumindest einem Teil der ersten Trägerfläche zu bilden, und wobei eine zweite Abdeckung (23) zum Befestigen an dem Träger angepasst ist, um eine zweite Verkleidung über zumindest einem Teil der zweiten Trägerfläche zu bilden, wobei der Träger eine Aufnahme (9) zum Aufnehmen der ersten Abdeckung und der zweiten Abdeckung aufweist, wobei die Aufnahme eine erste Vertiefung (11) zum Aufnehmen eines Rands (18) der ersten Abdeckung und eine zweite Vertiefung (13) zum Aufnehmen eines Rands (19) der zweiten Abdeckung aufweist, wobei die Aufnahme in zumindest einer von der ersten Vertiefung und der zweiten Vertiefung eine Polsterschicht (15) zum Polstern der in der Vertiefung aufgenommenen Abdeckung aufweist, **dadurch gekennzeichnet, dass** die erste Vertiefung und die zweite Vertiefung der Aufnahme Schiebesitze für die Ränder der ersten Abdeckung beziehungsweise der zweiten Abdeckung zur Verfügung stellen.

2. Gehäusestruktur nach Anspruch 1, und wobei die erste Fläche und die zweite Fläche des Trägers in einander entgegen gesetzte Richtungen weisen.

3. Gehäuse nach Anspruch 1 oder Anspruch 2, und wobei die Aufnahme einstückig mit dem Träger gebildet ist.

4. Gehäuse nach Anspruch 3, und wobei der Träger, der die Aufnahme umfasst, ein im Wesentlichen starres Teil aus gegossenem Kunststoff umfasst.

5. Gehäuse nach einem der Ansprüche 2 bis 4, und wobei sich die Aufnahme um den Träger herum an einer Kante davon erstreckt.

6. Gehäuse nach Anspruch 5, und wobei die Aufnahme eine geschlossene Schleife um die Kante oder Kanten des Trägers herum bildet.

7. Gehäuse nach Anspruch 5 oder Anspruch 6, und wobei sich die erste Vertiefung und die zweite Vertiefung auf einander gegenüberliegenden Seiten der Aufnahme befinden.

8. Gehäuse nach Anspruch 7, und wobei die Aufnahme zumindest in den Teilen von ihr, die neben den Vertiefungen liegen, eine Querschnittsform aufweist, die in etwa einem Buchstaben H entspricht.

9. Gehäuse nach einem der vorangehenden Ansprüche, und wobei die Polsterschicht einen Streifen aus elastomerem Material umfasst.

10. Gehäuse nach einem der vorangehenden Ansprüche, und wobei Polsterschichten sowohl in der ersten Vertiefung als auch in der zweiten Vertiefung zur Verfügung gestellt werden.

11. Gehäuse nach Anspruch 10, und wobei die Polsterschichten in der ersten Vertiefung und der zweiten Vertiefung zwei Polsterringe umfassen.

12. Gehäuse nach einem der vorangehenden Ansprüche, und wobei die erste Abdeckung und die zweite Abdeckung metallisches Material umfassen.

13. Gehäuse nach Anspruch 12, und wobei die erste Abdeckung und die zweite Abdeckung aus einem Magnesiummaterial hergestellt sind.

14. Gehäuse nach einem der vorangehenden Ansprüche, und wobei die erste Abdeckung und die zweite Abdeckung zusätzlich zu der Aufnahme Befestigungen an dem Träger aufweisen.

15. Gehäuse nach Anspruch 14, und wobei die erste Abdeckung und der Träger auf der ersten Seite davon komplementäre Formen aufweisen, die eine Befestigung der ersten Abdeckung an dem Träger unterstützen, und wobei die zweite Abdeckung und der Träger auf der zweiten Seite davon komplementäre Formen aufweisen, die eine Befestigung der zweiten Abdeckung an dem Träger unterstützen.

16. Gehäuse nach Anspruch 15, und wobei die jeweiligen komplementären Formen Schiebesitze für die erste Abdeckung und die zweite Abdeckung mit dem Träger zur Verfügung stellen, wobei die erste Abdeckung und die zweite Abdeckung bei Befestigung an dem Träger an diesen geklemmt werden.

17. Gehäuse nach einem der vorangehenden Ansprüche, und wobei zumindest eine der Flächen des Trägers eine Wand aufweist, die einer oder mehreren Komponenten des elektronischen Geräts eine interne Schutzzone zur Verfügung stellt.

18. Gehäuse nach Anspruch 17, und wobei die Wand in der Form eine geschlossene Schleifenform bildet und an der Innenseite der Wand eine Schicht aus Polstermaterial zur Verfügung gestellt wird.

19. Elektronisches Gerät mit einem Gehäuse nach einem der vorangehenden Ansprüche.

20. Elektronisches Gerät nach Anspruch 19, und wobei es sich bei dem Gerät um ein Hand gehaltenes tragbares Gerät handelt und das Gehäuse vor Unfallschäden an dem Gerät durch Fallenlassen oder falsche Handhabung durch einen Benutzer schützt.

21. Elektronisches Gerät nach Anspruch 19 oder Anspruch 20, und wobei das Gerät eine Funkkommunikationseinheit umfasst.

## Revendications

1. Structure de boîtier pour un dispositif électronique comprenant un support (1) contre lequel un ou plusieurs des composants du dispositif peuvent être adaptés, le support comprenant un premier côté de support et un second côté de support, un premier couvercle (21) conçu pour être fixé au support afin de former une première enceinte sur au moins une partie du premier côté du support et un second couvercle (23) conçu pour être fixé au support afin de former une seconde enceinte sur au moins une partie du second côté de support, dans laquelle le support comporte un réceptacle (9) destiné à recevoir les premier et second couvercles, le réceptacle comportant un premier évidement (11) destiné à recevoir un rebord (18) du premier couvercle et un second évidement (13) destiné à recevoir un rebord (19) du second couvercle, le réceptacle comportant dans au moins un des premier et second évidements une couche amortissante (15) destinée à amortir le couvercle reçu dans l'évidement, **caractérisée en ce que** les premier et second évidements du réceptacle fournissent des ajustements bloqués pour les rebords des premier et second couvercles respectivement.

2. Structure de boîtier selon la revendication 1 et dans laquelle les premier et second côtés du support s'orientent dans des directions mutuellement opposées.

3. Boîtier selon la revendication 1 ou la revendication 2 et dans lequel le réceptacle est formé de façon solidaire du support.

4. Boîtier selon la revendication 3 et dans lequel le support comprenant le réceptacle qui comprend une partie globalement rigide constituée de matière plastique moulée.

5. Boîtier selon l'une quelconque des revendications 2 à 4 et dans lequel le réceptacle s'étend autour du support au niveau d'un bord de celui-ci.

6. Boîtier selon la revendication 5 et dans lequel le réceptacle forme une boucle fermée autour du bord ou des bords du support.

7. Boîtier selon la revendication 5 ou la revendication 6 et dans lequel le premier évidement et le second évidement se situent sur des côtés mutuellement opposés du réceptacle.

8. Boîtier selon la revendication 7 et dans lequel le réceptacle comporte, au moins dans ses parties qui sont adjacentes aux évidements, une forme en coupe transversale qui est proche de la lettre H.

9. Boîtier selon l'une quelconque des revendications précédentes et dans lequel la couche amortissante comprend une bande de matériau élastomère.

10. Boîtier selon l'une quelconque des revendications précédentes et dans lequel les couches amortissantes sont prévues dans les deux premier et second évidements.

11. Boîtier selon la revendication 10 et dans lequel les couches amortissantes dans les premier et second évidements comprennent deux bagues amortissantes.

12. Boîtier selon l'une quelconque des revendications précédentes et dans lequel les premier et second couvercles comprennent un matériau métallique.

13. Boîtier selon la revendication 12 et dans lequel les premier et second couvercles sont constitués d'un matériau de magnésium.

14. Boîtier selon l'une quelconque des revendications précédentes et dans lequel les premier et second couvercles comportent des fixations au support en plus de celles du réceptacle.

15. Boîtier selon la revendication 14 et dans lequel le premier couvercle et le support sur son premier côté comportent des formations complémentaires qui facilitent la fixation du premier couvercle au support et le second couvercle et le support sur son second côté comportent des formations complémentaires qui facilitent la fixation du second couvercle au support.

16. Boîtier selon la revendication 15 et dans lequel les formations complémentaires respectives fournissent des ajustements bloqués des premier et second couvercles au support, les premier et second couvercles lorsqu'ils sont fixés au support étant serrés à celui-ci.

17. Boîtier selon l'une quelconque des revendications précédentes et dans lequel au moins l'un des côtés du support comporte une paroi fournissant une zone de protection interne à un ou plusieurs composants du dispositif électronique.

18. Boîtier selon la revendication 17 et dans lequel la paroi présente une forme de dessin en boucle fermée et une couche de matériau amortissant est prévue à l'intérieur de la paroi.

19. Dispositif électronique comportant un boîtier selon l'une quelconque des revendications précédentes.

20. Dispositif électronique selon la revendication 19 et dans lequel le dispositif est un dispositif portable dans une main et le boîtier protège le dispositif contre tout dommage accidentel provoqué par une chute ou une mauvaise manipulation d'un utilisateur.

21. Dispositif électronique selon la revendication 19 ou la revendication 20 et dans lequel le dispositif comprend une unité de radiocommunications.
